# EUROPÄISCHE PATENTSCHRIFT

(11) **EP 1 307 684 B1**
(45) Veröffentlichungstag und Bekanntmachung des Hinweises auf die Patenterteilung: **07.11.2007**
(21) Anmeldenummer: 01971885.7
(22) Anmeldetag: 07.08.2001
(51) Int. Cl.: F21K 7/00

(54) **LAMPE**
LAMP
LAMPE

(30) Priorität: 07.08.2000 DE 20013542 U
(43) Veröffentlichungstag der Anmeldung: 07.05.2003
(73) Patentinhaber: Zumtobel Lighting GmbH, 6850 Dornbirn (AT)
(72) Erfinder: WERNER, Walter, A-6850 Dornbirn (AT); GEIGINGER, Joachim, A-6845 Hohenems (AT)
(74) Vertreter: Schmidt-Evers, Jürgen
(86) Internationale Anmeldenummer: PCT/EP2001/009116
(87) Internationale Veröffentlichungsnummer: WO 2002/012783

(56) Entgegenhaltungen:
- EP-A- 0 848 206
- US-A- 5 301 090
- PATENT ABSTRACTS OF JAPAN vol. 1998, no. 14, 31. Dezember 1998 (1998-12-31) & JP 10 247401 A (SANYO ELECTRIC CO LTD), 14. September 1998 (1998-09-14)
- SMELA E ET AL: "PLANAR MICROFABRICATED POLYMER LIGHT-EMITTING DIODES" SEMICONDUCTOR SCIENCE AND TECHNOLOGY, INSTITUTE OF PHYSICS. LONDON, GB, Bd. 13, Nr. 4, 1. April 1998 (1998-04-01), Seiten 433-439, XP000739997 ISSN: 0268-1242

## Beschreibung

Die vorliegende Erfindung betrifft ein lichtemittierendes Element und eine Lampe, welche Licht mit Hilfe von lichtemittierenden Polymeren erzeugen.

In der Beleuchtungstechnik findet heutzutage entsprechend dem jeweiligen Anwendungsgebiet eine Reihe unterschiedlicher Lampentypen Verwendung. Während beispielsweise Glühbirnen besonders einfach aufgebaut und damit vielseitig einsetzbar sind, zeichnen sich Gasentladungslampen durch ihre in der Regel höhere Lichtausbeute aus. Allerdings erfordert das Betreiben von Gasentladungslampen wiederum einen höheren technischen Aufwand - insbesondere, wenn eine Helligkeitssteuerung erwünscht ist. Neben diesen beiden Lampentypen wurden zwischenzeitlich u.a. auch Leuchten entwickelt, bei denen lichtemittierende Dioden (LED) zum Einsatz kommen.

Lichtemittierende Polymere (LEP - light emitting polymers), oftmals auch organische LED's (OLED) genannt, sind seit einiger Zeit bekannt. Es handelt sich hierbei im wesentlichen um eine Substanz, die bei Anlegen eines elektrischen Feldes Licht in einer bestimmten Farbe emittiert. Heutzutage finden diese lichtemittierenden Polymere in erster Linie zur Hinterleuchtung von Tastaturen für Mobiltelefone oder Fernbedienungen Verwendung. Darüber hinaus ist auch der Einsatz in Displays und Bildschirmen angedacht. Dabei gibt es unterschiedliche Polymerarten, die Licht in verschiedenen Farben emittieren. Anwendungsbeispiele finden sich beispielsweise in den Veröffentlichungen US 6,002,206 und EP 0 966 018 der Firma Cambridge Display Technology LTD.

Aus der EP 0 848 206 A2 ist ferner eine Vorrichtung zur Beleuchtung von Theaterbühnen, TV-Studios und dergleichen bekannt, die durch eine flächige Schicht aus lichtemittierenden Polymeren gebildet wird. Diese bekannte Vorrichtung kann aus unterschiedlichen Segmenten bestehen, die aufgrund unterschiedlicher Spannung unterschiedliche Farben emittieren.

Eine Schwierigkeit, welche bisher den Einsatz von lichtemittierenden Polymeren zu Beleuchtungszwecken verhindert hat, besteht darin, daß großflächige Elemente mit lichtemittierenden Polymeren nur sehr aufwendig herzustellen sind. Dies deshalb, da zum Erzeugen des elektrischen Feldes zu beiden Seiten der Polymerschicht Elektroden angeordnet sein müssen. Bisher wurden hierfür mit leitendem Material beschichtete Platten verwendet. Diese allerdings großflächig und gleichzeitig lichtdurchlässig zu gestalten, war bisher nur mit erheblichem Aufwand möglich.

Die Erfindung betrifft ein lichtemittierends element mit den Merkmalen des Anspruchs 1. Im Gegensatz zu den bisher verwendeten flächigen Elektrodenschichten wird somit erfindungsgemäß ein Leiterbahn-Muster zum Erzeugen des elektrischen Feldes verwendet. Hierdurch besteht die Möglichkeit, für die isolierende Schicht, auf der die Leiterbahnen aufgebracht sind, ein einfaches lichtdurchlässiges Material, beispielsweise Kunststoff oder dergleichen zu verwenden. Vorzugsweise sind dabei die periodischen Leiterbahn-Muster der beiden Elektrodenschichten gegeneinander versetzt, so daß trotz der Verwendung von diskreten Elektroden in Form von Leiterbahnen ein möglichst homogenes elektrisches Feld über die Polymerschicht erzeugt wird. Hierdurch wird gewährleistet, daß über das gesamte lichtemittierende Element hinweg eine für das menschliche Auge gleichmäßige Leuchtdichte entsteht.

Die erfindungsgemäßen Elektrodenschichten sind auf besonders einfache Weise großflächig herzustellen. Darüber hinaus besteht die Möglichkeit, die auf diese Weise gebildeten lichtemittierenden Elemente einfach auf die gewünschte Form und Größte, die für den jeweiligen Zweck notwendig ist, zuzuschneiden.

Mit der vorliegenden Erfindung soll ferner ein neuartiger Lampentyp auf Basis dieser lichtemittierenden Elemente vorgestellt werden, der das Spektrum der bisher zur Verfügung stehenden Lampen erweitert. Ferner soll die Lampe hinsichtlich ihrer Farbcharakteristik eine möglichst homogene Lichtquelle darstellen.

Gemäß dem Anspruch 3 besteht die erfindungsgemäße Lampe aus einem Lampengehäuse, an dem an wenigstens einer Außenfläche lichtemittierende Elemente angeordnet sind, sowie aus einer in dem Lampengehäuse angeordneten Steuerschaltung zur Stromversorgung und zum Betreiben der lichtemittierenden Elemente. Die lichtemittierenden Elemente weisen jeweils eine Schicht aus lichtemittierenden Polymeren auf, wobei die Lampe mehrere lichtemittierende Elemente unterschiedlicher Art aufweist, die Licht in verschiedenen Farben emittieren. Erfindungsgemäß sind die lichtemittierenden Elemente in Gruppen angeordnet, wobei in jeder Gruppe zumindest ein lichtemittierendes Element jeder Farbe vorgesehen ist.

Gemäß der vorliegenden Erfindung wird also die Verwendung lichtemittierender Polymere zu Beleuchtungszecken vorgeschlagen, wodurch ein neuartiger Lampentyp geschaffen wird. Dabei gewährleistet die erfindungsgemäße gruppenweise Anordnung der lichtemittierenden Elemente im Vergleich zu der aus der EP 0 840 206 A2 bekannten Vorrichtung eine bessere Mischung des von den verschiedenen lichtemittierenden Elementen abgegebenen Lichts, so daß eine gleichmäßige Farbcharakteristik erzielt wird.

Da ein Vorteil der lichtemittierenden Polymere u.a. darin liegt, daß durch Verändern der Feldstärke des angelegten elektrischen Feldes die Helligkeit gesteuert werden kann, besteht die Möglichkeit, durch eine geeignete Ansteuerung die einzelnen Farbtöne in gewünschter Weise zu mischen und damit einen beliebigen Gesamtfarbton zu erzielen. Beispielsweise können Elemente, welche Licht in den Farben Rot, Grün und Blau emittieren, vorgesehen sein. Um die Mischung des von den einzelnen Elementen emittierten Lichts weiter zu verbessern, kann ferner vorgesehen sein, daß - von dem zu beleuchtenden Bereich aus gesehen - vor den lichtemittierenden Elementen eine lichtstreuende Schicht, beispielsweise in Form eines Diffusors angeordnet ist.

Die erfindungsgemäße Lampe kann die unterschiedlichsten Formen annehmen. Beispielsweise kann das Lampengehäuse die Form einer üblichen Leuchtstoffröhre aufweisen. In diesem Fall sind die lichtemittierenden Elemente vorzugsweise streifenförmig auf dem Umfang des zylinderförmigen Gehäuses angeordnet.

Im folgenden soll die Erfindung anhand der beiliegenden Zeichnung näher erläutert werden. Es zeigen:
Fig. 1 ein erstes Ausführungsbeispiel der erfindungsgemäßen Lampe;
Fig. 2 ein zweites Ausführungsbeispiel der erfindungsgemäßen Lampe;
Fig. 3a ein lichtemittierendes Element im Schnitt; und
Fig. 3b das in Figur 3a dargestellte lichtemittierende Element in Aufsicht.

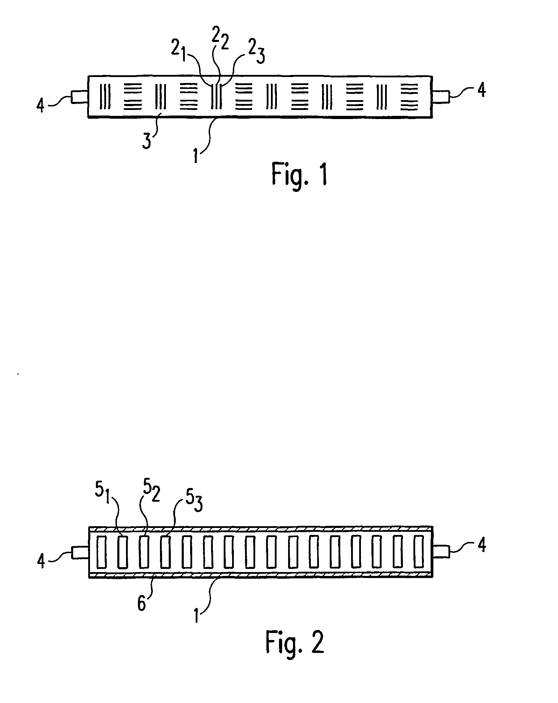

Bei der in Figur 1 dargestellten Lampe weist das Lampengehäuse 1 die Form und Abmessungen einer länglichen Leuchtstoffröhre auf. An beiden Enden des Gehäuses 1 sind Kontakte 4 zum Anschließen der Lampe an ein Stromnetz und evtl. Busleitungen zum Übertragen von Steuersignalen und Helligkeitsbefehlen angeordnet. Die Außenfläche des Lampengehäuses 1 ist von einer Vielzahl von dünnen streifenförmigen lichtemittierenden Elementen 2₁ bis 2₃ bedeckt.

Im vorliegenden Beispiel sind die lichtemittierenden Elemente 2₁ bis 2₃ jeweils in Gruppen 3 zu je drei lichtemittierenden Elementen 2₁ bis 2₃ angeordnet, wobei jeweils des erste lichtemittierende Element 2₁ einer solchen Gruppe 3 Licht in roter Farbe, das zweite Element 2₂ Licht in grüner Farbe und das dritte Element 2₃ Licht in blauer Farbe emittiert.

Das Ansteuern der lichtemittierenden Elemente 2₁ bis 2₃ erfolgt durch die innerhalb des Gehäuses 1 angeordnete und nicht dargestellte Steuerschaltung, welche durch eine geeignete Schaltung mit den einzelnen Elementen 2₁ bis 2₃ verbunden ist und diese entsprechend der gewünschten Helligkeit und dem gewünschten Farbton ansteuert. Durch Verändern des in einem lichtemittierenden Element 2₁ bis 2₃ erzeugten elektrischen Feldes kann die Intensität des von diesem Element emittierten Lichts variiert werden. Durch Regelung der einzelnen Farbintensitäten wird der gewünschte Farbton und die gewünschte Helligkeit erzeugt. Aufgrund der dichten Anordnung der lichtemittierenden Elemente 2₁ bis 2₃ unterschiedlicher Farbe und der kleinen Fläche einer einzelnen Gruppe 3 wird eine gute Farbdurchmischung erzielt, so daß ohne zusätzliche Maßnahmen der gewünschte Mischfarbton insgesamt erzeugt werden kann.

Im Gegensatz zu der in Figur 1 dargestellten Lampe sind bei der Lampe in Figur 2 die lichtemittierenden Elemente 5₁ bis 5₃ in Form von großflächigen Streifen auf dem Außenumfang des Lampengehäuses 1 angeordnet. Auch hier sind drei verschiedene Arten von Elementen 5₁ bis 5₃ vorgesehen, die jeweils Licht in einer anderen Farbe emittieren. Um trotz der großflächigen Anordnung der lichtemittierenden Elemente 5₁ bis 5₃ eine gute Farbdurchmischung zu erzielen, ist nunmehr zusätzlich an der Außenseite der Lampe eine lichtstreuende Schicht 6 in Form eines Diffusors angeordnet.

Wie auch LED's besitzen die lichtemittierenden Polymere den Vorteil, daß sie in ihrer Intensität gut steuerbar sind, so daß die erfindungsgemäße Lampe vielseitig einsetzbar ist und mit ihr eine Vielzahl von verschiedenen Farbtönen und Beleuchtungseffekten erzielt werden können.

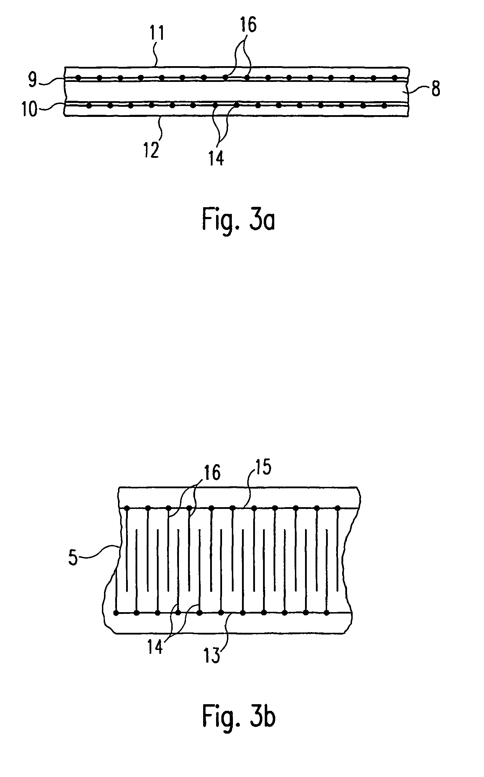

Anhand der Figuren 3a und 3b soll im folgenden der Aufbau eines großflächigen lichtemittierenden Elements 5 erläutert werden. Figur 3a zeigt dabei den Aufbau des Elements 5 im Schnitt. Dabei ist in der Mitte des Elements 5 die Polymerschicht 8 angeordnet, welche bei Anlegen eines geeigneten elektrischen Feldes Licht in der dem Polymer entsprechenden Farbe emittiert. An der Oberseite und an der Unterseite der Polymerschicht 8 sind jeweils eine Halbleiterschicht 9 bzw. 10 angeordnet, wobei eine der beiden Schichten - beispielsweise die Halbleiterschicht 9 - eine Löcher-induzierende Schicht ist, während die gegenüberliegende Schicht 10 eine Elektronen-induzierende Schicht ist. Die Anordnung aus der Polymerschicht und den beiden Halbleiterschichten 9 und 10 wiederum ist zwischen zwei Elektrodenschichten 11 und 12 angeordnet, wobei eine der beiden Schichten - beispielsweise die Schicht 11 - als Kathodenschicht fungiert, während die zweite Schicht 12 die Funktion einer Anodenschicht hat.

Dabei ist zumindest die dem zum beleuchtenden Bereich zugewandte Elektrodenschicht 11 oder 12 lichtdurchlässig. Beispielsweise handelt es sich um eine dünne durchsichtige Kunststoffschicht. Zum Erzeugen des elektrischen Feldes über die Polymerschicht 8 sind auf die den jeweiligen Halbleiterschichten 9 bzw. 10 zugewandten Seiten der Elektrodenschichten 11 und 12 Leiterbahnen 14 bzw. 16 aufgebracht. Diese Leiterbahnen 14, 16 sind die eigentlichen Elektroden zum Erzeugen des elektrischen Feldes.

Bei bisherigen organischen LED's waren die Elektroden üblicherweise als großflächige Schichten ausgebildet, auf deren der Polymerschicht zugewandten Seite eine leitende Schicht aufgedampft war. Diese Aufgabe wird nunmehr von den Leiterbahnen 14 und 16 übernommen, da auf diese Weise wesentlich einfacher lichtdurchlässige Elektrodenschichten erzeugt werden können. Eine mögliche Struktur der Leiterbahnen ist in Figur 3b dargestellt. Vorzugsweise handelt es sich dabei um ein periodisches Leiterbahn-Muster aus Längsleitungen 13 bzw. 15 sowie davon seitlich abstehenden Querleitungen 14 bzw. 16. Um ein möglichst gleichmäßiges elektrisches Feld über die gesamte Polymerschicht 8 zu erzeugen und damit eine gleichmäßige Helligkeitsdichte zu erzielen, sind die Leiterbahn-Muster der beiden Elektrodenschichten gegeneinander versetzt, wie dies in Figur 3b dargestellt ist. Durch diese quasi-überlappende Anordnung der Leiterbahn-Muster wird ein nahezu homogenes elektrisches Feld erzeugt.

Das in den Figuren 3a und 3b dargestellte erfindungsgemäße lichtemittierende Element zeichnet sich durch seinen einfachen Aufbau aus, durch den gewährleistet ist, daß auch großflächigen Elemente in den verschiedensten Formen auf einfache und schnelle Weise erstellt werden können. Beispielsweise besteht die Möglichkeit, sehr große zusammenhängende lichtemittierende Elemente zu bilden, die erst anschließend zu den gewünschten Formen zugeschnitten werden, um sie dann auf die Außenseite eines Lampengehäuses aufzubringen. Es müssen dann lediglich an den Enden des zugeschnittenen Elements die beiden Leiterbahn-Muster kontaktiert werden.

Die erfindungsgemäße neuartige Lampe ist somit vielseitig einsetzbar und bietet die Möglichkeit, eine Vielzahl unterschiedlicher Beleuchtungseffekte zu erzielen. Darüber hinaus kann mit Hilfe der großflächigen lichtemittierenden Elemente das Lampengehäuse nahezu vollständig bedeckt werden, so daß trotz der noch immer bestehenden relativ geringen Lichtausbeute von lichtemittierenden Polymeren eine für Beleuchtungszwecke ausreichende Helligkeit erzielt werden kann.

## Patentansprüche

1. Lichtemittierendes Element (5) für eine Lampe, aufweisend
eine flache Schicht (8) aus lichtemittierenden Polymeren,
zwei an den Flachseiten der Polymerschicht (8) angeordnete Halbleiterschichten (9, 10), und
zwei Elektrodenschichten (11, 12), die jeweils an der der Polymerschicht (8) gegenüberliegenden Seite einer Halbleiterschicht (9, 10) angeordnet sind und von denen zumindest eine Elektrodenschicht (9, 10) lichtdurchlässig ist,
**dadurch gekennzeichnet,**
**dass** die Elektrodenschichten (11, 12) jeweils aus einer isolierenden Schicht bestehen, auf deren der jeweiligen Halbleiterschicht (9, 10) zugewandten Seite periodische Muster aus Leiterbahnen (13-16) aufgebracht sind.

2. Lichtemittierendes Element nach Anspruch 1,
**dadurch gekennzeichnet,**
**dass** die periodischen Leiterbahn-Muster der beiden Elektrodenschichten (11, 12) gegeneinander versetzt sind.

3. Lampe zu Beleuchtungszwecken
mit einem Lampengehäuse (1), an dem an wenigstens einer Außenfläche lichtemittierende Elemente (2₁-2₃, 5₁-5₃) nach einem der Ansprüche 1 oder 2 angeordnet sind,
sowie mit einer in dem Lampengehäuse (1) angeordneten Steuerschaltung zur Stromversorgung und zum Betreiben der lichtemittierenden Elemente (2₁-2₃, 5₁-5₃).

4. Lampe nach Anspruch 3,
**dadurch gekennzeichnet,**
**dass** sie lichtemittierende Elemente (2₁-2_{3,} 5₁-5₃) unterschiedlicher Art aufweist, welche Licht in verschiedenen Farben emittieren.

5. Lampe nach Anspruch 4,
**dadurch gekennzeichnet,**
**dass** die lichtemittierenden Elemente (2₁-2₃) in Gruppen (3) angeordnet sind, wobei in jeder Gruppe (3) zumindest ein lichtemittierendes Element (2₁-2₃) jeder Farbe vorgesehen ist.

6. Lampe nach einem der Ansprüche 3 bis 5,
**dadurch gekennzeichnet,**
**dass** - von dem zu beleuchtenden Bereich aus gesehen - vor den lichtemittierenden (2₁-2₃, 5₁-5₃) Elementen eine lichtstreuende Schicht (6) angeordnet ist.

7. Lampe nach einem der Ansprüche 3 bis 6,
**dadurch gekennzeichnet,**
**dass** diese die Form einer üblichen Leuchtstoffröhre hat.

8. Lampe nach einem der Ansprüche 3 bis 7,
**dadurch gekennzeichnet,**
**dass** die lichtemittierenden Elemente streifenförmig (2₁-2₃) sind.

9. Lampe nach einem der Ansprüche 3 bis 8,
**dadurch gekennzeichnet,**
**dass** die lichtemittierenden Elemente (5₁-5₃) flächige Elemente sind.

## Claims

1. Light emitting element (5) for a lamp, having
a flat layer (8) of light emitting polymers,
two semiconductor layers (9, 10) arranged on the flat sides of the polymer layer (8), and
two electrode layers (11, 12), in each case arranged on the side of a semiconductor layer (9, 10) opposite to the polymer layer (8) and of which at least one electrode layer (9,10) is light permeable,
**characterised in that**,
the electrode layers (11, 12) are in each case comprised of an insulating layer on the side of which towards the semiconductor layer (9, 10) concerned there are applied periodical patterns of conductors paths (13-16).

2. Light emitting element according to claim 1,
**characterised in that**,
the periodical conductors path patterns of the two electrode layers (11, 12) are offset with respect to one another.

3. Lamp for illumination purposes
having a lamp housing (1) on which, on at least one external surface, there are arranged light emitting elements (2₁-2₃, 5₁-5₃) in accordance with claim 1 or 2, and having a control circuit arranged in the lamp housing (1) for the current supply and operation of the light emitting elements (2₁-2₃, 5₁-5₃).

4. Lamp according to claim 3,
**characterised in that**,
it has light emitting elements (2₁-2₃, 5₁-5₃) of different types, which emit light in different colours.

5. Lamp according to claim 4,
**characterised in that**,
the light emitting elements (2₁-2₃) are arranged in groups (3), wherein in each group (3) there is provided at least one light emitting element (2₁-2₃) of each colour.

6. Lamp according to any of claims 3 to 5,
**characterised in that**,
there is arranged in front - seen from the region to be illuminated - of the light emitting elements (2₁-2₃, 5₁-5₃) a light scattering layer (6).

7. Lamp according to any of claims 3 to 6,
**characterised in that**,
this has the form of a conventional fluorescent tube.

8. Lamp according to any of claims 3 to 7,
**characterised in that**,
the light emitting elements are strip-like (2₁-2₃).

9. Lamp according to any of claims 3 to 8,
**characterised in that**,
the light emitting elements (5₁-5₃) are areal elements.

## Revendications

1. Elément émetteur de lumière (5) d'une lampe présentant une couche plate de polymère (8) émetteur de lumière, deux couches de semi-conducteurs (9, 10) placées sur les côtés plats de la couche de polymère (8), et deux couches d'électrodes (11, 12) placées respectivement sur le côté d'une couche de semi-conducteurs (9, 10) opposé à la couche de polymère (8) et desquelles au moins une couche d'électrodes (11, 12) laisse passer la lumière,
**caractérisé en ce que** les couches d'électrodes (11, 12) sont composées respectivement d'une couche isolante sur le côté desquelles tourné vers les couches de semi-conducteurs (9, 10) respectives, des motifs périodiques de pistes conductrices sont appliqués.

2. Elément émetteur de lumière selon la revendication 1,
**caractérisé en ce que** les motifs périodiques de pistes conductrices des deux couches d'électrodes (11, 12) sont décalés les uns par rapport aux autres.

3. Lampe à des fins d'éclairage avec un boîtier de lampe (1) sur lequel des éléments émetteurs de lumière (2₁-2₃, 5₁-5₃) selon l'une des revendications 1 ou 2 sont placés sur au moins une surface extérieure, ainsi qu'avec un circuit de commande placé dans le boîtier de lampe (1) pour l'alimentation électrique et pour faire fonctionner les éléments émetteurs de lumière (2₁-2₃, 5₁-5₃).

4. Lampe selon la revendication 3,
**caractérisée en ce qu'**elle présente des éléments émetteurs de lumière (2₁-2₃, 5₁-5₃) de différents types qui émettent de la lumière dans différentes couleurs.

5. Lampe selon la revendication 4,
**caractérisée en ce que** les éléments émetteurs de lumière (2₁-2₃) sont disposés en groupes (3), moyennant quoi dans chaque groupe (3) au moins un élément émetteur de lumière (2₁-2₃) de chaque couleur est prévu.

6. Lampe selon l'une des revendications 3 à 5,
**caractérisée en ce que**, vu depuis la zone à éclairer, une couche diffusant la lumière (6) est placée devant les éléments émetteurs de lumière (2₁-2₃, 5₁-5₃).

7. Lampe selon l'une des revendications 3 à 6,
**caractérisée en ce que** celle-ci a la forme d'un tube de substance luminescente courant.

8. Lampe selon l'une des revendications 3 à 7,
**caractérisée en ce que** les éléments émetteurs de lumière (2₁-2₃) sont en forme de bande.

9. Lampe selon l'une des revendications 3 à 8,
**caractérisée en ce que** les éléments émetteurs de lumière (2₁-2₃) sont des éléments à deux dimensions.
